(19) Europäisches Patentamt
European Patent Office
Office européen des brevets

(11) **EP 2 651 036 B1**

(12) **EUROPÄISCHE PATENTSCHRIFT**

(45) Veröffentlichungstag und Bekanntmachung des Hinweises auf die Patenterteilung:
**17.09.2014   Patentblatt 2014/38**

(51) Int Cl.:
***H03K 17/95*** *(2006.01)*

(21) Anmeldenummer: **12164136.9**

(22) Anmeldetag: **13.04.2012**

(54) **Induktiver Näherungssensor**

Inductive proximity sensor

Détecteur d'approximation inductif

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(43) Veröffentlichungstag der Anmeldung:
**16.10.2013   Patentblatt 2013/42**

(73) Patentinhaber: **Sick AG
79183 Waldkirch/Breisgau (DE)**

(72) Erfinder:
• **Thoss, Sascha
79106 Freiburg (DE)**
• **Machul, Olaf
79249 Merzhausen (DE)**
• **Baak, Josef
79183 Waldkirch (DE)**

(74) Vertreter: **Manitz, Finsterwald & Partner GbR
Martin-Greif-Strasse 1
80336 München (DE)**

(56) Entgegenhaltungen:
**DE-A1- 19 947 380      DE-A1-102007 007 551
DE-A1-102009 028 619     US-A1- 2005 231 360**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen induktiven Näherungssensor, der ausgestaltet ist, eine Schwingung in Form eines analogen Signals auszuwerten, dessen Amplitude von der An- bzw. Abwesenheit und/oder dem Abstand eines elektrisch leitfähigen Objekts abhängt, sowie ein Verfahren zur Feststellung der Anwesenheit und/oder des Abstands eines elektrisch leitfähigen Objekts.

Induktive Näherungssensoren detektieren elektrisch leitfähige Metalle auf Grundlage des Wirbelstromprinzips. Z.B. mittels eines elektrischen Schwingkreises aus einer Spule und einem Kondensator (LC-Schwingkreis) wird ein magnetisches Wechselfeld aufgebaut, das über die Spule des Schwingkreises in den Raum gerichtet abgestrahlt wird. Gelangt ein elektrisch leitfähiges Objekt (im Folgenden auch "Target" genannt) in den Wirkungsbereich des Wechselfeldes, werden durch das Wechselfeld im Target Wirbelströme induziert, die wiederum ein Magnetfeld hervorrufen, das dem anregenden Magnetfeld entgegengesetzt gerichtet ist. Die Erzeugung der Wirbelströme entzieht dem anregenden Magnetfeld Energie und beeinflusst damit die Impedanz der Spule bzw. dämpft den LC-Schwingkreis. Ein von dem LC-Schwingkreis ausgegebenes Ausgangssignal bildet die Schwingung des Schwingkreises als Strom- oder Spannungsverlauf ab. Das Ausgangssignal weist dabei typischerweise Frequenzen in der Nähe einer Resonanzfrequenz des Schwingkreises auf, bei welcher der Schwingkreis besonders gut zu Schwingungen angeregt werden kann. Im Frequenzbereich um die Resonanzfrequenz nimmt die Schwingungsintensität innerhalb eines Frequenzbandes des Ausgangssignals ab.

Die Schwingungsamplitude des Ausgangssignals stellt ein Maß für die Dämpfung des Schwingkreises dar, und erlaubt somit die Detektion und die Bestimmung des Abstands des Targets zu demjenigen Element, an dem das analoge Signal mit der Schwingung dem Einfluss des Targets unterliegt. Dieses Element kann beispielsweise ein Sensorelement des Näherungssensors sein. Bei dem Target kann es sich zum Beispiel um eine Schaltfahne handeln, die über den Näherungssensor ein Schaltsignal auslösen kann.

Für die zuverlässige Feststellung der Anwesenheit und/oder des Abstands des Targets ist es erforderlich, aus dem Ausgangssignal des LC-Schwingkreises die Amplitudeninformation präzise zu bestimmen. Dies erfolgt üblicherweise mit Hilfe von analogen Schaltungen, die z.B. analoge Gleichrichter umfassen. Oftmals ist außerdem bei entsprechenden Vorrichtungen oder Verfahren nur eine Schwellenwertdetektion, aber keine kontinuierliche Abstandsmessung vorgesehen. In diesem Fall weisen die analogen Schaltungen beispielsweise einen Peak-Detektor oder einen Komparator auf. Ein im Stand der Technik übliches und oft eingesetztes Detektionsverfahren umfasst beispielsweise die analoge Gleichrichtung des Ausgangssignals des LC-Schwingkreises mit anschließender Filterung und dem abschließenden Vergleich des gefilterten Signals mit einer Schaltschwelle über einen Komparator.

Temperaturänderungen, welche die Impedanz des LC-Schwingkreises beeinflussen, können zu Verfälschungen des Ausgangssignals führen. Es sind deshalb Verfahren zur Kompensation dieses Effektes vorgeschlagen worden. Ein solches Verfahren ist beispielsweise in der europäischen Patentschrift EP 0 070 796 B1 beschrieben. Die dort offenbarte analoge Kompensation des Temperatureinflusses erfordert eine relativ aufwändige Schaltung.

Der Einfluss des Targets auf das Ausgangssignal des Schwingkreises ist sehr stark abstandsabhängig, da das magnetische Feld im Nahbereich mit der dritten Potenz in den Raum hinein abnimmt. Typische Schaltabstände zwischen einem Target und dem Sensor betragen daher nur wenige Millimeter. Die Qualität der Abstandsdetektion und die damit verbundene Möglichkeit, vergleichsweise große Schaltabstände zu realisieren, hängen unter anderem von der Messgenauigkeit des Ausgangssignals des Schwingkreises ab. Daher ist es vorteilhaft, das analoge Ausgangssignal zu einem möglichst frühen Zeitpunkt seiner Prozessierung in ein digitales Signal zu wandeln, um äußere elektromagnetische Störeinflüsse weitestgehend auszuschließen. Die Digitalisierung des analogen Ausgangssignals des Schwingkreises eines induktiven Näherungssensors wird beispielsweise in der Offenlegungsschrift DE 10 2007 007 551 A1 beschrieben. Die darin offenbarte Schaltung wandelt das analoge Eingangssignal in einen digitalen, pulshäufigkeitsmodulierten Datenstrom, der direkt der Schwingungsamplitude des Schwingkreises entspricht. Die dort offenbarte Art der Digitalisierung beruht auf einer komplexen rückgekoppelten Schaltung.

Der Erfindung liegt die Aufgabe zugrunde, einen induktiven Näherungssensor mit sicherem und robustem Betrieb auf möglichst einfache und kostengünstige Weise zu ermöglichen.

Diese Aufgabe wird durch einen induktiven Näherungssensor mit den Merkmalen des Anspruchs 1 bzw. mit einem Verfahren zur Feststellung der Anwesenheit und/oder des Abstands eines elektrisch leitfähigen Objekts mit den Merkmalen des Anspruchs 11 gelöst. Bevorzugte Ausgestaltungen sind Gegenstand von Unteransprüchen.

Der erfindungsgemäße induktive Näherungssensor zeichnet sich dadurch aus, dass er wenigstens einen A/D-Wandler, der das analoge Ausgangssignal in ein digitales Eingangssignal für einen Mischer wandelt, und wenigstens einen Mischer umfasst. Der Mischer ist dabei dazu vorgesehen, das digitale Eingangssignal mit einem digitalen Bezugssignal zu einem digitalen Ausgangssignal zu multiplizieren, wobei das digitale Bezugssignal mit dem digitalen Eingangssignal identisch ist oder sich von dem digitalen Eingangssignal nur durch einen konstanten Faktor unterscheidet.

Dadurch, dass das von dem induktiven Näherungssensor auzuwertende analoge Signal bereits in einem frühen Verarbeitungsstadium in ein digitales Eingangssignal gewandelt wird, ist der erfindungsgemäße induktive Näherungssensor besonders robust gegenüber äußeren elektromagnetischen Störeinflüssen. Nach der Digitalisierung des Signals umfasst dieses weiterhin eine Schwingung, aus deren Amplitude die Abstandsinformation gewonnen werden kann. Da das Signal aber nun digital vorliegt, ist die dazu vorgesehene weitere Verarbeitung des Signals auf einfache Weise digital möglich und braucht folglich nicht durch aufwändige analoge Schaltungen realisiert zu werden. Insbesondere umfasst das digitale Mischereingangssignal die vollständige Abstandsinformation als kontinuierliches Signal (in Form der digitalen Abtastwerte). Daher kann nicht nur die Anwesenheit des Targets durch Vergleich mit einem Schwellenwert detektiert werden, sondern auch ein kontinuierliches Maß für den Abstand des Targets ausgegeben werden. Ist lediglich eine binäre Anwesenheitsdetektion beabsichtigt, kann durch Speicherung des Schwellenwerts in digitaler Form auf einfache Weise der Schaltabstand festgelegt bzw. modifiziert werden.

Die erfindungsgemäße Realisierung sieht ferner vor, dass das digitale Eingangssignal durch einen Mischer mit einem digitalen Bezugssignal multipliziert wird. Der Mischer kann dabei eine eigenständige digitale Prozessierungseinheit darstellen oder auch als Teil eines Programmablaufs beispielsweise mit einem Mikroprozessor ausgeführt werden. Das digitale Bezugssignal unterscheidet sich von dem digitalen Eingangssignal, mit dem es multipliziert wird, erfindungsgemäß nur durch einen konstanten Faktor, der auch Eins betragen kann, so dass in diesem Fall das digitale Eingangssignal und das digitale Bezugssignal identisch sind. Die Multiplikation des digitalen Eingangssignals mit dem digitalen Bezugssignal entspricht insofern einer Quadrierung des digitalen Eingangssignals und gegebenenfalls einer Skalierung mit einem konstanten Faktor. Diese Quadrierung stellt einen wesentlichen Schritt zur Gewinnung der Amplitudeninformation aus dem digitalen Eingangssignal dar.

Betrachtet man das von dem induktiven Näherungssensor auszuwertende Signal als harmonische Schwingung oder Überlagerung mehrerer harmonischer Schwingungen, gilt für die Multiplikation im Mischer die folgende Formel für das Produkt zweier Sinusfunktionen:

$$U_1 \cdot \sin(2 \cdot \pi \cdot f_1 \cdot t) \cdot U_2 \cdot \sin(2 \cdot \pi \cdot f_2 \cdot t) = \tfrac{1}{2} \cdot U_1 \cdot U_2 \cdot (\cos(2 \cdot \pi \cdot (f_1 - f_2) \cdot t) - \cos(2 \cdot \pi \cdot (f_1 + f_2) \cdot t)),$$

wobei $U_1$ und $U_2$ die Amplituden und $f_1$ und $f_2$ die Frequenzen der Schwingung sind und t die Zeit bezeichnet. Unterscheiden sich die beiden multiplizierten Schwingungen nicht in ihrer Frequenz (d.h. $f_1 = f_a = f$) und in ihrer Amplitude lediglich um einen konstanten Faktor A, ergibt sich

$$U \cdot \sin(2 \cdot \pi \cdot f \cdot t) \cdot A \cdot U \cdot \sin(2 \cdot \pi \cdot f \cdot t) = \tfrac{1}{2} \cdot A \cdot U^2 \cdot (1 - \cos(2 \cdot \pi \cdot 2f \cdot t)).$$

Folglich weist das Produkt der Schwingungen einen Schwingungsanteil mit der doppelten Frequenz $2f$ sowie einen Gleichanteil auf. Die Amplitude $\tfrac{1}{2} \cdot A \cdot U^2$ der multiplizierten Schwingung wirkt sich dabei sowohl auf die frequenzverdoppelte Schwingung als auch auf den Gleichanteil aus, so dass aus dem Betrag des Gleichanteils die Amplitudeninformation auf einfache Weise extrahiert werden kann. Dass die Amplitude dabei durch Quadrierung und Multiplikation mit $\tfrac{1}{2} \cdot A$ verändert wird, wirkt sich nicht nachteilig auf die Ermittlung der Abstandsinformation aus, da einerseits leicht auf die ursprüngliche Amplitude U zurückgerechnet werden kann und andererseits die Amplitude U der Schwingung ohnehin in der Regel nicht linear mit den Targetabstand zusammenhängt. Wichtig ist daher lediglich, dass die Amplitudeninformation eindeutig einem Targetabstand, beispielsweise durch Eichung oder theoretische Berechnung, zugeordnet werden kann. Dies wird weder durch die Quadrierung noch durch eine sonstige Multiplikation beeinträchtigt.

Der Vorteil der Quadrierung zur Ermittlung des Gleichanteils eines Signals gegenüber einer üblichen Gleichrichtung des Signals durch Absolutwertbildung ergibt sich insbesondere daraus, dass bei der Absolutwertbildung bei der üblichen Gleichrichtung durch das Anwenden der Betragsfunktion hochfrequente Anteile erzeugt werden, welche das eigentliche Signal überlagern können, so dass Information verloren geht oder verfälscht wird. Durch die Quadrierung wird dieser Effekt vermieden, was zu einer höheren Genauigkeit des induktiven Näherungssensors führt.

Der erfindungsgemäße induktive Näherungssensor ermöglicht es somit auf einfache Weise, einerseits durch Digitalisierung des Signals die Robustheit gegenüber elektromagnetischen Störeinflüssen gleich zu Beginn der Signalverarbeitung sicherzustellen und andererseits durch Multiplikation des digitalen Eingangssignals im Wesentlichen mit sich selbst die Amplitudeninformation aus der Schwingung des analogen Signals zugänglich zu machen. Die Digitalisierung eröffnet zudem vielfältige weitere Möglichkeiten der digitalen Signalverarbeitung wie etwa eine digitale Filterung und eine digitale Linearisierung des Signals, für die ansonsten speziell ausgestaltete analoge Schaltungen notwendig wären.

Das durch die Multiplikation im Mischer erzeugte digitale Ausgangssignal mit der Abstandsinformation kann von dem induktiven Näherungssensor unmittelbar in digitaler Form ausgegeben werden. Es kann aber auch ein D/A-Wandler vorgesehen sein, der das digitale Ausgangssignal zunächst in ein analoges Ausgangssignal wandelt, das letztlich ausgegeben wird.

Die Schwingung kann mit einem externen oder einem in den Näherungssensor integrierten Sender erzeugt und von einem Empfänger im induktiven Näherungssensor erfasst werden. Eine Dämpfung dieser Schwingung durch ein zu detektierendes elektrisch leitfähiges Objekt, insbesondere wenn durch das Wechselfeld der Schwingung darin Wirbelströme induziert werden, kann dann nachgewiesen und wie beschrieben erfindungsgemäß ausgewertet werden.

Vorzugsweise umfasst der induktive Näherungssensor jedoch ein Sensorelement mit einem Schwingkreis, der insbesondere ein LC-Schwingkreis sein kann. Das an dem induktiven Näherungssensor anliegende analoge Signal entspricht dann der Schwingung dieses Schwingkreises. Ein Schwingkreis stellt eine einfache Möglichkeit dar, ein analoges Schwingungssignal zu erzeugen, das zudem direkt von der Bedämpfung durch ein elektrisch leitfähiges Objekt abhängig ist, wobei die Dämpfung durch die Induzierung von Wirbelströmen in dem Objekt durch das von dem Schwingkreis aufgebaute Wechselfeld erzeugt wird. Die Amplitudeninformation des Schwingkreises, die ein Maß für die Dämpfung der Schwingung ist, wird dann wie beschrieben erfindungsgemäß ausgewertet. Die Integration des Sensorelements mit dem Schwingkreis in den induktiven Näherungssensor ermöglicht insbesondere eine kompakte Bauweise des induktiven Näherungssensors.

Gemäß besonders bevorzugten Ausführungsformen des erfindungsgemäßen induktiven Näherungssensors umfasst dieser ein erstes Tiefpassfilter, das in Signalrichtung nach dem Mischer angeordnet ist. Dieses Tiefpassfilter ermöglicht es, das digitale Ausgangssignal von höherfrequenten Anteilen zu befreien, so dass insbesondere der Gleichanteil ausgegeben wird, in dem wie oben gezeigt die Amplitudeninformation und somit die Abstandsinformation enthalten sind.

Vorzugsweise weist das erste Tiefpassfilter eine Grenzfrequenz auf, die kleiner ist als die doppelte Frequenz der Schwingung. Das Tiefpassfilter lässt also Frequenzen unterhalb dieser Grenzfrequenz im Wesentlichen unverändert durch und filtert Frequenzen oberhalb dieser Grenzfrequenz aus dem Signal aus. Dadurch, dass die Grenzfrequenz kleiner ist als die doppelte Frequenz der Schwingung, werden insbesondere solche Frequenzanteile herausgefiltert, die bei der Multiplikation im Mischer entstanden sind und gerade die doppelte Frequenz im Vergleich zu den in den Mischer eintretenden Signalen aufweisen.

In einer besonders vorteilhaften Ausführung lässt das erste Tiefpassfilter im Wesentlichen ausschließlich den Gleichanteil des durch das Filter geführten Signals passieren. Eine dementsprechend besonders niedrig gewählte Grenzfrequenz des Tiefpassfilters filtert somit nicht nur die Anteile mit der durch die Mischung verdoppelten Frequenz heraus, sondern möglicherweise zusätzlich vorhandene, z.B. durch Störeinflüsse hervorgerufene sonstige Schwingungsanteile, so dass die im Gleichanteil des digitalen Ausgangssignals enthaltene Abstandsinformation noch präziser bestimmt werden kann.

In einer weiteren bevorzugten Ausführungsform des erfindungsgemäßen induktiven Näherungssensors umfasst dieser eine Filtereinrichtung, die in Signalrichtung vor dem Mischer angeordnet ist und durch die ein Gleichanteil eines durch die Filtereinrichtung geführten Signals abgetrennt wird. Insbesondere kann das Abtrennen des Gleichanteils digital erfolgen, wodurch auf eine weitere analoge Komponente verzichtet werden kann. Zwar sollten idealerweise weder das analoge Signal noch das daraus gewandelte digitale Eingangssignal vor dem Mischer überhaupt einen Gleichanteil aufweisen, da die Schwingung, insbesondere wenn sie von einem Schwingkreis erzeugt ist, im Wesentlichen reine Sinusschwingungen bzw. Überlagerungen von Sinusschwingungen aufweisen sollte. Jedoch kann es bei den in der Praxis verwendeten Komponenten, insbesondere in den dafür anfälligen A/D-Wandlern, dazu kommen, dass das Signal einen gewissen Gleichanteil (Offset) aufweist, der auch zeitlich veränderlich sein kann (Offsetdrift). Die genannte Ausführungsform mit einer Filtereinrichtung weist den Vorteil auf, dass ein derartiger Offset bzw. eine derartige Offsetdrift bereits vor dem ersten Schritt zur Ermittlung des Amplitudensignals im Mischer beseitigt wird. Auf diese Weise wird die Funktion der Multiplikation im Mischer, nämlich die Erzeugung eines Gleichanteils, der die Abstandsinformation aufweist, gewährleistet, da ansonsten die Abstandsinformation durch einen Offset verfälscht würde.

Insbesondere ist es bevorzugt, wenn die Filtereinrichtung ein zweites Tiefpassfilter, das im Wesentlichen nur einen Gleichanteil des Signals passieren lässt, und einen Subtrahierer umfasst, wobei der Subtrahierer und das zweite Tiefpassfilter derart angeordnet sind, dass der Subtrahierer die Differenz zwischen dem ungefilterten Signal und dem vom Tiefpassfilter ausgegebenen Gleichanteil dieses Signals ausgibt. Das zweite Tiefpassfilter und der Subtrahierer wirken auf diese Weise als Einheit so zusammen, dass letztlich ein Gleichanteil eines durch diese Einheit geführten Signals abgetrennt wird. Dies entspricht der Funktion eines Hochpassfilters, das alternativ als die genannte Filtereinrichtung eingesetzt werden könnte.

Die Verwendung des Begriffs "zweites" Tiefpassfilter dient zur Unterscheidung gegenüber dem weiter oben beschriebenen "ersten" Tiefpassfilter und soll nicht so verstanden werden, dass nicht auch eine Realisierung möglich wäre, bei der zwar ein "zweites" aber kein "erstes" Tiefpassfilter vorgesehen ist.

Damit bei der Umwandlung des analogen Signals in das digitale Eingangssignal des Mischers keine Information verloren geht, muss gemäß dem Nyquist-Shannon-Theorem die Frequenz, mit der das analoge Signal im A/D-Wandler abgetastet wird, mindestens doppelt so groß sein wie der Anteil mit der höchsten Frequenz im abgetasteten Signal. Ist dies nicht der Fall, werden Anteile mit Frequenzen, die über der halben Abtastfrequenz liegen, zwar mit korrekter Amplitude, jedoch mit zu geringer Frequenz in das digitale Signal überführt, was auch als Aliasing bezeichnet wird. Dabei kann es dazu kommen, dass Anteile des analogen Signals, die verschiedenen Frequenzen entsprechen, im digitalen Signal auf dieselbe Frequenz abgebildet werden und sich also überlagern, so dass Information verloren geht. Wenn allerdings das zu wandelnde analoge Signal Frequenzen lediglich in einem definierten Bereich (Frequenzband) aufweist, kann es trotz eines Abtastens mit einer nach dem Nyquist-Shannon-Theorem zu niedrigen Frequenzen möglich sein, dass die Frequenzen des analogen Signals zwar im digitalen Signal auf andere Frequenzen abgebildet werden, es jedoch im digitalen Signal zu keiner Überlagerung ursprünglich verschiedener Frequenzen kommt. Somit geht trotz der Frequenzveränderung keine Information verloren. Dass die Digitalisierung eines analogen Signals trotz zu geringer Abtastfrequenz dennoch informationsverlustfrei erfolgt, trifft allerdings nur für gewisse geeignete Abtastfrequenzen zu. Die gezielte Wahl einer solchen geeigneten, nach dem Nyquist-Shannon-Theorem eigentlich zu geringen Abtastfrequenz entspricht dem Prinzip der sogenannten Bandpassunterabtastung.

Da es sich bei der von dem induktiven Näherungssensor auszuwertenden Schwingung, insbesondere wenn sie von einem Schwingkreis erzeugt wurde, um ein Signal handelt, das Frequenzanteile im Wesentlichen lediglich in einem definierten Frequenzband um eine (Haupt-)Frequenz der Schwingung (z.B. eine Resonanzfrequenz des Schwingkreises) herum aufweist, kann das genannte Prinzip der Bandpassunterabtastung auf dieses Signal angewandt werden.

Bei einer möglichen Ausführungsform des erfindungsgemäßen induktiven Näherungssensors weist der A/D-Wandler eine Abtastfrequenz auf, die größer als die doppelte Frequenz der Schwingung ist. In diesem Fall ist das Nyquist-Shannon-Theorem im Wesentlichen erfüllt. Die Verwendung eines A/D-Wandlers mit einer derartigen Abtastfrequenz zur Abtastung eines analogen Signals erfordert keine weitere Berücksichtigung möglicher Frequenzverschiebungen.

In einer besonders bevorzugten Ausführungsform des erfindungsgemäßen induktiven Näherungssensors entspricht die Abtastfrequenz des A/D-Wandlers dagegen einer nach dem Prinzip der Bandpassunterabtastung geeigneten Frequenz. Die Abtastfrequenz kann genau dann als geeignet angesehen werden, wenn das gesamte Frequenzband des analogen Signals nach einer Abtastung mit dieser Abtastfrequenz so auf Frequenzen des digitalen Eingangssignals übertragen wird, dass keine zwei verschiedenen Frequenzen im analogen Signal auf dieselbe Frequenz im digitalen Signal übertragen werden. Der Vorteil der Bandpassunterabtastung besteht darin, auch bei Schwingungen mit einem hochfrequenten Frequenzband, beispielsweise um eine (Haupt-)Frequenz der Schwingung von 540 kHz, gängige und kostengünstige A/D-Wandler mit typischen Abtastraten von beispielsweise 400 kHz verwenden zu können und nicht A/D-Wandler mit einer Abtastfrequenz gemäß dem Nyquist-Shannon-Theorem, also von etwa 1,1 MHz oder mehr, einsetzen zu müssen. Derartige A/D-Wandler mit vergleichsweise hohen Abtastfrequenzen wären wesentlich teurer und weisen einen wesentlich höheren Leistungsverbrauch auf als gängige A/D-Wandler mit niedrigeren Abtastfrequenzen. Da für eine Echtzeitverarbeitung des digitalen Signals die weiteren Prozessierungseinheiten wie etwa der Mischer, der beispielsweise durch einen Mikroprozessor realisiert sein kann, bei einer entsprechend hohen Taktung arbeiten müssen, sind bereits dadurch der Abtastfrequenz praktische obere Grenzen gesetzt. Durch Verwendung der Bandpassunterabtastung kann dagegen die Frequenz der Schwingung des induktiven Näherungssensors auch sehr hoch sein. Insbesondere ermöglicht eine niedrige Abtastfrequenz eine geringe Taktung der weiteren digitalen Signalverarbeitung, die deshalb auch als Software implementiert sein kann.

Bei einer weiteren bevorzugten Ausführungsform des erfindungsgemäßen induktiven Näherungssensors weist der A/D-Wandler eine Abtastfrequenz auf, die dynamisch an eine Änderung der Frequenz der Schwingung und/ oder an eine Änderung der Bandbreite des analogen Signals anpassbar ist. Eine solche Anpassung ist insbesondere dann von Vorteil, wenn die Abtastfrequenz gemäß dem Prinzip der Bandpassunterabtastung unterhalb der doppelten Frequenz der Schwingung liegt. Da die Abtastfrequenz in diesem Fall nicht beliebig sein kann, sondern, wie vorstehend erläutert, geeignet gewählt sein muss, kann es, wenn sich das Frequenzband des analogen Signals ändert, erforderlich werden, eine geeignete Anpassung der Abtastfrequenz vorzunehmen. Die Änderung des Frequenzbands des analogen Signals kann beispielsweise in einer Änderung der Bandbreite und/oder der Frequenz der Schwingung bestehen.

Die Aufgabe wird weiterhin mit einem Verfahren mit den Merkmalen des Anspruchs 11 gelöst. Die Vorteile des erfindungsgemäßen Verfahrens und besonders bevorzugte Ausgestaltungen ergeben sich in analoger Weise aus den obigen Schilderungen zu entsprechenden Ausführungsformen der erfindungsgemäßen Vorrichtung und deren Vorteilen.

Eine besonders vorteilhafte Ausführungsform des erfindungsgemäßen Verfahrens umfasst das Modifizieren des digitalen Eingangssignals und/oder des digitalen Ausgangssignals zur Kompensation eines Temperatureinflusses auf das analoge Signal. Dabei kann der Temperatureinfluss auf das analoge Signal z.B. eine Folge eines Temperatureinflusses auf einen Schwingkreis des induktiven Näherungssensors oder auf einzelne Komponenten des Näherungssensors sein. Störende Einflüsse der Temperatur auf Messungen mit induktiven Näherungssensoren sind bekannt und im Wesentlichen verstanden. Es kann daher eine temperaturabhängige Kompensation dieser Einflüsse vorgenommen werden. Besonders vorteilhaft ist es, wenn diese Kompensation auf das digitale Signal angewendet wird, weil im Zuge der digitalen Signalverarbeitung beispielsweise mittels eines Mikroprozessors vielfältige Manipulationen des Signals auf besonders einfache Weise möglich sind. Die digitale Temperaturkompensation kann dabei beispielsweise durch Interpolation oder durch Verwenden einer Look-up-Tabelle erfolgen.

Gemäß einer besonders bevorzugten Ausführungsform des erfindungsgemäßen induktiven Näherungssensors umfasst dieser einen Mikroprozessor, der geeignet ist, Verfahrensschritte gemäß dem erfindungsgemäßen Verfahren oder gemäß besonders bevorzugten Ausgestaltungen dieses Verfahrens auszuführen. Die Umsetzung der Verfahrensschritte in einem Mikroprozessor stellt eine besonders flexible und einfache Ausführungsform dar, weil ein Mikroprozessor als einzelne Einheit eine Vielzahl verschiedener Verfahrensschritte ausführen kann.

Besonders bevorzugt ist es, wenn der wenigstens eine A/D-Wandler des induktiven Näherungssensors in dem Mikroprozessor integriert ist. In diesem Fall kann der induktive Näherungssensor als ein einzelnes Modul oder, wenn der induktive Näherungssensor ein Sensorelement umfasst, aus lediglich zwei Modulen, nämlich dem Sensorelement und dem Mikroprozessor gefertigt sein.

Eine weitere vorteilhafte Ausführungsform des erfindungsgemäßen induktiven Näherungssensors sieht vor, dass der induktive Näherungssensor eine anwendungsspezifische integrierte Schaltung (ASIC) umfasst, die geeignet ist, Verfahrensschritte gemäß dem erfindungsgemäßen Verfahren oder gemäß besonders bevorzugten Ausgestaltungen des erfindungsgemäßen Verfahrens auszuführen. Die Verwendung eines speziellen ASIC gewährleistet einen hohen Integrationsgrad des induktiven Näherungssensors. Der ASIC kann auf die gewünschten Verfahrensschritte hin optimiert entworfen sein, so dass diese besonders effizient, beispielsweise schnell und/oder stromsparend, ausgeführt werden. Bei hoher Stückzahl kann zudem die Verwendung von anwendungsspezifischen integrierten Schaltungen kostengünstiger als beispielsweise die Verwendung eines allgemein einsetzbaren Mikroprozessors sein.

Im Folgenden wird die Erfindung anhand einer beispielhaften Ausführungsform unter Bezug auf die beiliegende schematische Figur im Detail erläutert. Dabei zeigt

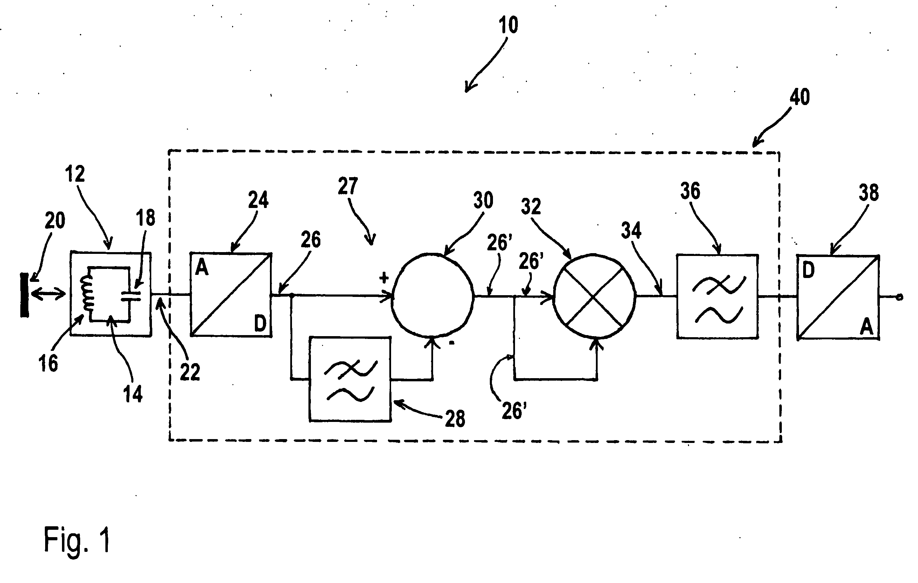

Fig. 1    ein Blockschaltbild einer Ausführungsform des erfindungsgemäßen induktiven Näherungssensors.

In Fig. 1 ist ein erfindungsgemäßer induktiver Näherungssensor 10 als Blockschaltbild gezeigt. Der Näherungssensor 10 umfasst ein Sensorelement 12 mit einem LC-Schwingkreis 14, wobei der LC-Schwingkreis 14 aus einer Spule 16 und einem Kondensator 18 aufgebaut ist und insbesondere in einem Frequenzbereich um eine Resonanzfrequenz zu Schwingungen angeregt werden kann. Eine zum Betrieb des Schwingkreises 14 und des gesamten induktiven Näherungssensors 10 vorgesehene Strom-/ Spannungsversorgung ist nicht gezeigt. Die Schwingung des LC-Schwingkreises 14 wird von dem Sensorelement 12 als analoges Signal 22 ausgegeben. In Abhängigkeit von dem Abstand eines elektrisch leitfähigen Objekts (Target) 20 zu dem Sensorelement 12 ist die Schwingung des LC-Schwingkreises 14 gedämpft, was sich insbesondere auf die Amplitude des analogen Signals 22 auswirkt.

Das analoge Signal 22 des LC-Schwingkreises 14 wird möglichst unmittelbar einem A/D-Wandler 24 zugeführt, um das analoge Signal 22 zu digitalisieren und so die Anfälligkeit für elektromagnetische Störeinflüsse weitestgehend zu verringern. Der A/D-Wandler 24 weist eine Abtastfrequenz auf, die geringer als die doppelte Resonanzfrequenz des LC-Schwingkreises 14 ist. Daher können gemäß dem Nyquist-Shannon-Theorem die Frequenzen des analogen Signals 22 nicht unverändert in das digitale Eingangssignal 26 übertragen werden, sondern werden auf geringere Frequenzen abgebildet. Die Abtastfrequenz des A/D-Wandlers 24 entspricht einer im Hinblick auf die Resonanzfrequenz des LC-Schwingkreises 14 und die Bandbreite des analogen Signals 22 geeignet angepassten Abtastfrequenz, die es nach dem Prinzip der Bandpassunterabtastung ermöglicht, das Frequenzband des analogen Signals 22 trotz der geringen Abtastfrequenz eindeutig auf ein Frequenzband des von dem A/D-Wandler 24 ausgegebenen digitalen Eingangssignals 26 zu übertragen. Die in der Amplitude der Schwingungen enthaltene Abstandsinformation bleibt dadurch erhalten und wird nicht verfälscht.

Das vom A/D-Wandler 24 ausgegebene digitale Eingangssignal 26 passiert anschließend eine Filtereinrichtung 27, die ein zweites Tiefpassfilter 28 und einen Subtrahierer 30 umfasst. Dabei wird das digitale Eingangssignal 26 sowohl dem zweiten Tiefpassfilter 28 als auch ungefiltert dem Subtrahierer 30 als Minuend zugeführt. Das zweite Tiefpassfilter 28 lässt im Wesentlichen nur einen Gleichanteil des digitalen Eingangssignals 26 passieren, der dem Subtrahierer 30 als Subtrahend zugeführt wird. Im Subtrahierer 30 wird somit der Gleichanteil des digitalen Eingangssignals 26 von dem digitalen Eingangssignal 26 abgezogen, so dass die Filtereinrichtung 27 das digitale Eingangssignal 26' frei von einem zuvor möglicherweise vorhandenen Gleichanteil ausgibt (mit Bezugsziffer 26' wird im Folgenden das digitale Eingangssignal bezeichnet, nachdem es die Filtereinrichtung 27 passiert hat). Ein solcher Gleichanteil könnte als Folge eines Offsets des LC-Schwingkreises 14 bereits im analogen Signal 14 vorhanden gewesen sein. Ein Offset könnte aber auch durch den A/D-Wandler 24 im digitalen Eingangssignal 26 hervorgerufen worden sein. Auch langsame Veränderungen eines solchen Offsets (Offsetdrift) werden durch das Zusammenwirken des zweiten Tiefpassfilters 28 und des Subtrahierers 30 als Filtereinrichtung 27 zuverlässig aus dem digitalen Eingangssignal 26 entfernt.

Der Begriff "digitales Eingangssignal" wird hier für das durch den A/D-Wandler 24 digitalisierte Signal verwendet, das - ggf. über Zwischenstufen, wie der Filtereinrichtung 27 - dem Mischer 32 eingegeben wird (daher "Eingangssignal"). Bei der beschriebenen Ausführungsform wird das digitale Eingangssignal 26 durch die Filtereinrichtung 27 von seinem Gleichanteil befreit und dann als entsprechend modifiziertes digitales Eingangssignal 26' in den Mischer 32 eingegeben.

Das von möglichen Gleichanteilen befreite digitale Eingangssignal 26' wird den beiden Eingängen eines Mischers 32 zugeführt, in dem eine Multiplikation der beiden Eingangssignale 26' erfolgt. In dem gezeigten Ausführungsbeispiel sind die beiden Eingangssignale 26' identisch, im Rahmen der Erfindung könnten sie sich jedoch auch um einen konstanten Faktor unterscheiden. Das von dem Mischer 32 ausgegebene digitale Ausgangssignal 34 entspricht einer Quadrierung des von einem Gleichanteil befreiten digitalen Eingangssignals 26'. Aufgrund dieser Quadrierung setzt sich das digitale Ausgangssignal 34 entsprechend den Gesetzen für das Produkt trigonometrischer Funktionen aus zwei grundsätzlich unterschiedlichen Anteilen zusammen: Zum einen weist das digitale Ausgangssignal 34 Schwingungsanteile auf, deren Frequenzen gerade einer Verdoppelung der Frequenzen des digitalen Eingangssignals 26' entsprechen; zum anderen entsteht im digitalen Ausgangssignal 34 durch die Quadrierung ein neuer Gleichanteil, dessen Betrag dem halben Quadrat der Schwingungsamplitude des digitalen Eingangssignals 26' entspricht. Da die Information über den Abstand des Targets 20 von dem Sensorelement 12 in der Schwingungsamplitude des analogen Signals 22 enthalten war, kann nun direkt aus dem Betrag des Gleichanteils des digitalen Ausgangssignals 34 diese Information bestimmt werden.

In der vorliegenden Ausführungsform wird dazu das digitale Ausgangssignal 34 einem ersten Tiefpassfilter 36 zugeführt, das im Wesentlichen nur den genannten Gleichanteil des digitale Ausgangssignals 34 passieren lässt, während die frequenzverdoppelten Anteile ausgefiltert werden. Das von dem ersten Tiefpassfilter 36 ausgegebene digitale Signal stellt dann ein direktes kontinuierliches Maß für den Abstand des Targets 20 von dem Sensorelement 12 des induktiven Näherungssensors 10 dar.

Da die Abstandsinformation in digitaler Form vorliegt, kann sie auf einfache Weise weiter verrechnet werden. Beispielsweise ist eine digitale Temperaturkompensation vorgesehen, durch die der Einfluss der Temperatur auf die Abstandsmessung kompensiert wird und die hier nicht gezeigt ist. Zudem kann das digitale Ausgangssignal im Zuge weiterer digitaler Signalverarbeitung, die ebenfalls in Fig. 1 nicht gezeigt ist, leicht entsprechend einer Eichung oder theoretischen Berechnungen so linearisiert werden, dass sein Wert direkt proportional zum Abstand des Targets 20 vom Sensorelement 12 ist.

Bei der gezeigten Ausführungsform wird das derart prozessierte digitale Ausgangssignal 34 schließlich mittels eines D/A-Wandlers 38 in ein analoges Ausgangssignal gewandelt und ausgegeben. Das analoge Ausgangssignal weist dabei den Betrag des verarbeiteten digitalen Ausgangssignals 34 und somit die Abstandsinformation als Spannungswert auf. Alternativ ist es möglich, dass die Abstandsinformation als Stromstärke des analogen Ausgangssignals ausgegeben wird.

Bei dem Ausführungsbeispiel der Fig. 1 sind der A/D-Wandler 24, die Filtereinrichtung 27 mit dem zweiten Tiefpassfilter 28 und dem Subtrahierer 30, der Mischer 32 und das erste Tiefpassfilter 36 Bestandteile eines Mikroprozessors 40, in dem die Filterungen, die Subtraktion und die Multiplikation als Software implementiert sind und der den A/D-Wandler 24 als integrierten Baustein umfasst.

Bezugszeichenliste

| | |
|---|---|
| 10 | induktiver Näherungssensor |
| 12 | Sensorelement |
| 14 | LC-Schwingkreis |
| 16 | Spule |
| 18 | Kondensator |
| 20 | elektrisch leitfähiges Objekt, Target |
| 22 | analoges Signal |
| 24 | A/D-Wandler |
| 26, 26' | digitales Eingangssignal |
| 27 | Filtereinrichtung |
| 28 | zweites Tiefpassfilter |
| 30 | Subtrahierer |
| 32 | Mischer |
| 34 | digitales Ausgangssignal |
| 36 | erstes Tiefpassfilter |
| 38 | D/A-Wandler |
| 40 | Mikroprozessor |

**Patentansprüche**

1. Induktiver Näherungssensor (10) zur Feststellung der Anwesenheit und/oder des Abstands eines elektrisch leitfähigen Objekts (20), der ausgestaltet ist, eine Schwingung in Form eines analogen Signals (22) auszuwerten, dessen Amplitude von der An- bzw. Abwesenheit und/oder dem Abstand eines elektrisch leitfähigen Objekt (20) abhängt, **dadurch gekennzeichnet, dass** der induktive Näherungssensor (10) wenigstens einen A/D-Wandler (24), der dieses analoge Signal (22) in ein digitales Eingangssignal (26, 26') wandelt, und wenigstens einen Mischer (32) umfasst, der das digitale Eingangssignal (26, 26') mit einem digitalen Bezugssignal zu einem digitalen Ausgangssignal (34) multipliziert, wobei das digitale Bezugssignal mit dem digitalen Eingangssignal (26, 26') identisch ist oder sich von dem digitalen Eingangssignal (26, 26') nur durch einen konstanten Faktor unterscheidet.

2. Vorrichtung nach Anspruch 1, **dadurch gekennzeichnet, dass** der induktive Näherungssensor ein Sensorelement (12) mit einem Schwingkreis (14), insbesondere einem LC-Schwingkreis mit einer Resonanzfrequenz, umfasst, wobei der Schwingkreis ein analoges Signal (22) zur Verfügung stellt, das von der Bedämpfung des Schwingkreises (14) durch das elektrisch leitfähige Objekt abhängt.

3. Vorrichtung nach Anspruch 1 oder 2, **dadurch gekennzeichnet, dass** der induktive Näherungssensor (10) ein erstes Tiefpassfilter (36) umfasst, das in Signalrichtung nach dem Mischer (32) angeordnet ist.

4. Vorrichtung nach Anspruch 3, **dadurch gekennzeichnet, dass** das erste Tiefpassfilter (36) eine Grenzfrequenz aufweist, die kleiner ist als die doppelte Frequenz der Schwingung.

5. Vorrichtung nach Anspruch 3 oder 4, **dadurch gekennzeichnet, dass** das erste Tiefpassfilter (36) vorzugsweise im Wesentlichen nur einen Gleichanteil eines durch das erste Tiefpassfilter (36) geführten Signals passieren lässt.

6. Vorrichtung nach zumindest einem der vorstehenden Ansprüche, **dadurch gekennzeichnet, dass** der induktive Näherungssensor (10) eine Filtereinrichtung (27) umfasst, die in Signalrichtung vor dem Mischer (32) angeordnet ist und durch die ein Gleichanteil eines durch die Filtereinrichtung (27) geführten Signals abgetrennt wird.

7. Vorrichtung nach Anspruch 6, **dadurch gekennzeichnet, dass** das Abtrennen des Gleichanteils durch die Filtereinrichtung (27) digital erfolgt.

8. Vorrichtung nach Anspruch 6 oder 7, **dadurch gekennzeichnet, dass** die Filtereinrichtung (27) des induktiven Näherungssensors (10) ein zweites Tiefpassfilter (28), das vorzugsweise im Wesentlichen nur einen Gleichanteil eines durch das zweite Tiefpassfilter (28) geführten Signals passieren lässt, und einen Subtrahierer (30) umfasst, die derart angeordnet sind, dass der Subtrahierer (30) die Differenz zwischen dem ungefilterten Signal und dem Gleichanteil dieses Signals ausgibt.

9. Vorrichtung nach zumindest einem der vorstehenden Ansprüche, **dadurch gekennzeichnet, dass** der A/D-Wandler (24) eine Abtastfrequenz aufweist, die entweder größer als die doppelte Frequenz der Schwingung ist oder einer nach dem Prinzip der Bandpassunterabtastung geeigneten Frequenz entspricht.

10. Vorrichtung nach zumindest einem der vorstehenden Ansprüche, **dadurch gekennzeichnet, dass** der A/D-Wandler (24) eine Abtastfrequenz aufweist, die dynamisch an eine Änderung der Frequenz der Schwingung und/oder an eine Änderung einer Bandbreite des analogen Signals (22) anpassbar ist.

**11.** Verfahren zur Feststellung der Anwesenheit und/oder des Abstands eines elektrisch leitfähigen Objekts (20) mit einem induktiven Näherungssensor (10), der ausgestaltet ist, eine Schwingung in Form eines analogen Signals (22) auszuwerten, dessen Amplitude von der An- bzw. Abwesenheit und/oder dem Abstand eines elektrisch leitfähigen Objekts (20) abhängt,
**dadurch gekennzeichnet, dass**
das Verfahren umfasst:

- Wandeln des analogen Signals (22) zu einem digitalen Eingangssignal (26, 26'), und
- Umrechnen des digitalen Eingangssignals (26, 26') zu einem digitalen Ausgangssignal (34),

wobei das Umrechnen umfasst:

- Multiplizieren des digitalen Eingangssignals (26, 26') mit einem digitalen Bezugssignal, wobei das digitale Bezugssignal mit dem digitalen Eingangssignal (26, 26') identisch ist oder sich von dem digitalen Eingangssignal (26, 26') nur durch einen konstanten Faktor unterscheidet.

**12.** Verfahren nach Anspruch 11,
**dadurch gekennzeichnet, dass**
das Umrechnen des digitalen Eingangssignals (26, 26') zu einem digitalen Ausgangssignal (34) ferner umfasst:

- Tiefpassfiltern des multiplizierten Signals derart, dass vorzugsweise im Wesentlichen nur ein Gleichanteil des multiplizierten Signals erhalten bleibt.

**13.** Verfahren nach Anspruch 11 oder 12,
**dadurch gekennzeichnet, dass**
das Verfahren ferner umfasst:

- Abtrennen eines Gleichanteils des digitalen Eingangssignals (26) von dem digitalen Eingangssignal (26).

**14.** Verfahren nach einem der Ansprüche 11 bis 13,
**dadurch gekennzeichnet, dass**
das Wandeln des analogen Signals (22) zu einem digitalen Eingangssignal (26) ferner umfasst:

- dynamisches Anpassen der Abtastfrequenz eines A/D-Wandlers (24), der zur Wandlung des analogen Signals (22) zu einem digitalen Eingangssignal (26, 26') verwendet wird, an eine Änderung der Frequenz der Schwingung und/oder an eine Änderung einer Bandbreite des analogen Signals (22).

**15.** Verfahren nach einem der Ansprüche 11 bis 14,
**dadurch gekennzeichnet, dass**
das Verfahren ferner umfasst:

- Modifizieren des digitalen Eingangssignals (26, 26') und/oder des digitalen Ausgangssignals (34) zur Kompensation eines Temperatureinflusses auf das analoge Signal (22).

**16.** Vorrichtung nach einem der Ansprüche 1 bis 10,
**dadurch gekennzeichnet, dass**
der induktive Näherungssensor (10) einen Mikroprozessor (40) umfasst, der geeignet ist, Verfahrensschritte gemäß einem Verfahren nach den Ansprüchen 11 bis 15 auszuführen.

**17.** Vorrichtung nach Anspruch 16,
**dadurch gekennzeichnet, dass**
der wenigstens eine A/D-Wandler (24) des induktiven Näherungssensors (10) in dem Mikroprozessor (40) integriert ist.

**18.** Vorrichtung nach einem der Ansprüche 1 bis 10,
**dadurch gekennzeichnet, dass**
der induktive Näherungssensor (10) eine anwendungsspezifische integrierte Schaltung (ASIC) umfasst, die geeignet ist, Verfahrensschritte gemäß einem Verfahren nach den Ansprüchen 11 bis 15 auszuführen.

**Claims**

1. An inductive proximity sensor (10) for determining the presence and/or the distance of an electrically conductive object (20) which is designed to evaluate an oscillation in the form of an analog signal (22) whose amplitude depends on the presence or absence and/or on the distance of an electrically conductive object (20),
   **characterized in that**
   the inductive proximity sensor (10) comprises at least one A/ D converter (24) which converts this analog signal (22) into a digital input signal (26, 26') and comprises at least one mixer (32) which multiplies the digital input signal (26, 26') by a digital reference signal to form a digital output signal (34), wherein the digital reference signal is identical to the digital input signal (26, 26') or only differs from the digital input signal (26, 26') by a constant factor.

2. An apparatus in accordance with claim 1,
   **characterized in that**
   the inductivity proximity sensor comprises a sensor element (12) having a resonant circuit (14), in particular an LC resonant circuit having a resonant frequency, wherein the resonant circuit provides an analog signal (22) which depends on the damping of the resonant circuit (14) by the electrically conductive object.

3. An apparatus in accordance with claim 1 or claim 2,
   **characterized in that**
   the inductive proximity sensor (10) comprises a first low pass filter (36) which is arranged after the mixer (32) in the signal direction.

4. An apparatus in accordance with claim 3,
   **characterized in that**
   the first low pass filter (36) has a limit frequency which is smaller than twice the frequency of the oscillation.

5. An apparatus in accordance with claim 3 or claim 4,
   **characterized in that**
   the first low pass filter (36) preferably substantially allows only a constant component of a signal guided through the first low pass filter (36) to pass.

6. An apparatus in accordance with at least one of the preceding claims,
   **characterized in that**
   the inductive proximity sensor (10) comprises a filter device (27) which is arranged in front of the mixer (32) in the signal direction and by which a constant component of a signal guided through the filter device (27) is separated.

7. An apparatus in accordance with claim 6,
   **characterized in that**
   the separation of the constant component takes place digitally by the filter device (27).

8. An apparatus in accordance with claim 6 or claim 7,
   **characterized in that**
   the filter device (27) of the inductive proximity sensor (10) comprises a second low pass filter (28) which preferably substantially only allows a constant component of a signal guided through the low pass filter (28) to pass and comprises a subtractor (30), said second low pass filter and said subtractor being arranged such that the subtractor (30) outputs the difference between the unfiltered signal and the constant portion of this signal.

9. An apparatus in accordance with at least one of the preceding claims,
   **characterized in that**
   the A/D converter (24) has a sampling frequency which is either larger than twice the frequency of the oscillation or corresponds to a frequency suitable in accordance with the principle of the band pass undersampling.

10. An apparatus in accordance with at least one of the preceding claims,
    **characterized in that**
    the A/D converter (24) has a sampling frequency which can be dynamically adapted to a change in the frequency of the oscillation and/or to a change in a bandwidth of the analog signal (22).

11. A method of determining the presence and/or the distance of an electrically conductive object (20) having an inductive proximity sensor (10) which is designed to evaluate an oscillation in the form of an analog signal (22) whose amplitude depends on the presence or absence and/or on the distance of an electrically conductive object (20),
**characterized in that**
the method comprises:

- converting the analog signal (22) into a digital input signal (26, 26'); and
- converting the digital signal (26, 26') into a digital output signal (34),

wherein the conversion comprises:

- multiplying the digital input signal (26, 26') by a digital reference signal, wherein the digital reference signal is identical to the digital input signal (26, 26') or only differs from the digital input signal (26, 26') by a constant factor.

12. A method in accordance with claim 11,
**characterized in that**
the conversion of the digital signal (26, 26') into a digital output signal (34) further comprises:

- low pass filtering of the multiplied signal such that preferably substantially only a constant component of the multiplied signal is maintained.

13. A method in accordance with claim 11 or claim 12,
**characterized in that**
the method further comprises:

- separating a constant component of the digital input signal (26) from the digital input signal (26).

14. A method in accordance with any one of the claims 11 to 13,
**characterized in that**
the conversion of the analog signal (22) into a digital input signal (26) further comprises:

- dynamically adapting the sampling frequency of an A/D converter (24) which is used for converting the analog signal (22) into a digital input signal (26, 26') to a change in the frequency of the oscillation and/or to a change in a bandwidth of the analog signal (22).

15. A method in accordance with any one of the claims 11 to 14,
**characterized in that**
the method further comprises:

- modifying the digital input signal (26, 26') and/or the digital output signal (34) for compensating a temperature influence on the analog signal (22).

16. An apparatus in accordance with any one of the claims 1 to 10,
**characterized in that**
the inductive proximity sensor (10) comprises a microprocessor (40) which is suitable to carry out method steps in accordance with a method in accordance with the claims 11 to 15.

17. An apparatus in accordance with claim 16,
**characterized in that**
the at least one A/D converter (24) of the inductive proximity sensor (10) is integrated in the microprocessor (40).

18. An apparatus in accordance with any one of the claims 1 to 10,
**characterized in that**
the inductive proximity sensor (10) comprises an application-specific integrated circuit (ASIC) which is suitable to carry out method steps in accordance with a method in accordance with the claims 11 to 15.

**Revendications**

**1.** Détecteur inductif de proximité (10) pour constater la présence et/ou la distance d'un objet électriquement conducteur (20), qui est conçu pour évaluer une oscillation sous la forme d'un signal analogique (22), dont l'amplitude dépend de la présence de l'absence et/ou de la distance d'un objet électriquement conducteur (20), **caractérisé en ce que** le détecteur inductif de proximité (10) comprend au moins un convertisseur A/N (24), qui convertit ce signal analogique (22) en un signal d'entrée numérique (26, 26'), et au moins un mélangeur (32), qui multiplie le signal d'entrée numérique (26, 26') avec un signal de référence numérique pour donner un signal de sortie numérique (34), dans lequel le signal de référence numérique est identique avec le signal d'entrée numérique (26, 26') ou bien se distingue du signal d'entrée numérique (26, 26') uniquement par un facteur constant.

**2.** Dispositif selon la revendication 1, **caractérisé en ce que** le détecteur inductif de proximité comprend un élément détecteur (12) avec un circuit oscillant (14), en particulier un circuit oscillant LC avec une fréquence de résonance, dans lequel le circuit oscillant met à disposition un signal analogique (22) qui dépend de l'amortissement du circuit oscillant (14) par l'objet électriquement conducteur.

**3.** Dispositif selon la revendication 1 ou 2, **caractérisé en ce que** le détecteur inductif de proximité (10) comprend un premier filtre passe-bas (36), qui est agencé après le mélangeur (32) dans la direction du signal.

**4.** Dispositif selon la revendication 3, **caractérisé en ce que** le premier filtre passe-bas (36) présente une fréquence limite qui est inférieure au double de la fréquence de l'oscillation.

**5.** Dispositif selon la revendication 3 ou 4, **caractérisé en ce que** le premier filtre passe-bas (36) laisse de référence passer essentiellement uniquement une part continue d'un signal mené à travers le premier filtre passe-bas (36).

**6.** Dispositif selon l'une au moins des revendications précédentes, **caractérisé en ce que** le détecteur inductif de proximité (10) comprend un système à filtre (27), qui est agencé avant le mélangeur (32) dans la direction du signal, et au moyen duquel une part continue d'un signal mené à travers le système à filtre (27) est séparée.

**7.** Dispositif selon la revendication 6, **caractérisé en ce que** la séparation de la part continue a lieu au moyen du système à filtre (27) de manière numérique.

**8.** Dispositif selon la revendication 6 ou 7, **caractérisé en ce que** le système à filtre (27) du détecteur inductif de proximité (10) comprend un second filtre passe-bas (28) qui laisse de préférence passer essentiellement uniquement une part continue d'un signal mené à travers le second filtre passe-bas (28), et un soustracteur (30), lesquels sont agencés de telle façon que le soustracteur (30) délivre la différence entre le signal non filtré et la part continue de ce signal.

**9.** Dispositif selon l'une au moins des revendications précédentes, **caractérisé en ce que** le convertisseur A/N (24) présente une fréquence de palpage qui est supérieure au double de la fréquence de l'oscillation, ou qui correspond à une fréquence convenable selon le principe d'un sous-palpage de bande passante.

**10.** Dispositif selon l'une au moins des revendications précédentes, **caractérisé en ce que** le convertisseur A/N (24) présente une fréquence de palpage qui peut être ajustée de façon dynamique à une variation de la fréquence de l'oscillation et/ou qui peut être ajustée à une variation d'une largeur de bande du signal analogique (22).

**11.** Procédé pour constater la présence et/ou la distance d'un objet électriquement conducteur (20) avec un détecteur inductif de proximité (10) qui est conçu pour évaluer une oscillation sous la forme d'un signal analogique (22), dont l'amplitude dépend de la présence ou de l'absence et/ou de la distance d'un objet électriquement conducteur (20), **caractérisé en ce que** le procédé comprend les étapes consistant à :

- convertir le signal analogique (22) en un signal d'entrée numérique (26, 26'), et
- recalculer le signal d'entrée numérique (26, 26') en un signal de sortie numérique (34),

dans lequel le recalcul comprend :

- la multiplication du signal d'entrée numérique (26, 26') avec un signal de référence numérique, tel que le signal de référence numérique est identique avec le signal d'entrée numérique (26, 26') ou bien se distingue du signal d'entrée numérique (26, 26') uniquement par un facteur constant.

**12.** Procédé selon la revendication 11,
**caractérisé en ce que** le recalcul de signal d'entrée numérique (26, 26') pour donner un signal de sortie numérique (34) comprend en outre :

- l'opération consistant à filtrer par un filtre passe-bas le signal multiplié, de manière à conserver de préférence essentiellement uniquement une part continue du signal multiplié.

**13.** Procédé selon la revendication 11 ou 12,
**caractérisé en ce que** le procédé comprend en outre :

- l'opération consistant à séparer une part continue du signal d'entrée numérique (26) depuis le signal d'entrée numérique (26).

**14.** Procédé selon l'une des revendications 11 à 13,
**caractérisé en ce que** la conversion du signal analogique (22) pour donner un signal d'entrée numérique (26) comprend en outre :

- l'opération consistant à ajuster de façon dynamique la fréquence de palpage d'un convertisseur A/N (24), qui est utilisé pour convertir le signal analogique (22) et donner un signal d'entrée numérique (26, 26'), à une variation de la fréquence de l'oscillation et/ou à une variation d'une largeur de bande du signal analogique (22).

**15.** Procédé selon l'une des revendications 11 à 14,
**caractérisé en ce que** le procédé comprend en outre :

- l'opération consistant à modifier le signal d'entrée numérique (26, 26') et/ou le signal de sortie numérique (34) pour la compensation d'une influence de la température sur le signal analogique (22).

**16.** Dispositif selon l'une des revendications 1 à 10,
**caractérisé en ce que** le détecteur inductif de proximité (10) comprend un microprocesseur (40) qui est approprié pour exécuter les étapes d'un procédé selon les revendications 11 à 15.

**17.** Dispositif selon la revendication 16,
**caractérisé en ce que** ledit au moins un convertisseur A/N (24) du détecteur inductif de proximité (10) est intégré dans le microprocesseur (40).

**18.** Dispositif selon l'une des revendications 1 à 10,
**caractérisé en ce que** le détecteur inductif de proximité (10) comprend un circuit intégré spécifique à l'application (ASIC), qui est approprié pour exécuter les étapes d'un procédé selon les revendications 11 à 15.

Fig. 1

**EP 2 651 036 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0070796 B1

- DE 102007007551 A1